# EUROPÄISCHE PATENTSCHRIFT

(11) **EP 1 135 267 B1**
(45) Veröffentlichungstag und Bekanntmachung des Hinweises auf die Patenterteilung: **05.03.2003**
(21) Anmeldenummer: 99958048.3
(22) Anmeldetag: 16.11.1999
(51) Int. Cl.: B44F 1/14, B44C 1/24, G03F 7/00

(54) **VERFAHREN ZUR DEKORATIVEN GESTALTUNG EINER LACKIERTEN SUBSTRATOBERFLÄCHE**
METHOD FOR DECORATIVELY SHAPING A PAINTED SUBSTRATE SURFACE
PROCEDE DE REALISATION D'UN EFFET DECORATIF SUR LA SURFACE PEINTE D'UN SUBSTRAT

(30) Priorität: 19.11.1998 DE 19853386
(43) Veröffentlichungstag der Anmeldung: 26.09.2001
(73) Patentinhaber: E.I. DU PONT DE NEMOURS AND COMPANY, Wilmington Delaware 19898 (US)
(72) Erfinder: FRANKE, Hilmar, D-49565 Bramsche (DE); SIMMROCK, Hans-Ulrich, D-40627 Düsseldorf (DE); WEIDENHAMMER, Petra, D-81827 Münchenn (DE)
(74) Vertreter: Gille Hrabal Struck Neidlein Prop Roos
(86) Internationale Anmeldenummer: EP9908797
(87) Internationale Veröffentlichungsnummer: WO00030869

(56) Entgegenhaltungen:
- EP-A- 0 439 050
- EP-A- 0 540 455
- EP-A- 0 896 259
- DE-C- 19 613 383
- US-A- 4 978 593

## Beschreibung

Die Erfindung betrifft ein Verfahren zur dekorativen Gestaltung einer Überzugsschicht auf bestimmten Substraten sowie die nach dem Verfahren erhaltenen Substrate. Das erfindungsgemäße Verfahren kann insbesondere Anwendung finden bei der dekorativen Oberflächengestaltung von Fahrzeugkarosserien, deren Bauteilen sowie Fahrzeugteilen.

Insbesondere aus dem Bereich der Automobillackierung sind vielfältige Beispiele für dekorative Oberflächengestaltungen bekannt. Beispielsweise zählen dazu individuelle Lackierungen, beispielsweise Effektlackierungen, Lackierungen in Sonderfarbtönen oder Lackierungen in Form von Bildern, Mustern oder Ornamenten, aber auch das Aufbringen entsprechend gestalteter Klebefolien.

Die DE-C-196 13 383 beschreibt einen Abformstempel, mit dem Mikrostrukturen auf Gegenstände aufgebracht werden können. Zum Beispiel können Mikrostrukturen zur Erzeugung einer destruktiven Interferenz in eine auf eine Bildröhre aufgebrachte Lackschicht zwecks Entspiegelung eingeprägt werden.
Die EP-A-0540455 betrifft ein Verfahren zur Herstellung von mit optischen Effekten (Beugung und Reflexion von Licht) versehenen bedruckten Folien.
Aufgabe der Erfindung ist die Bereitstellung eines Verfahrens zur dekorativen Gestaltung einer Überzugsschicht auf bestimmten Substraten. Das Verfahren soll dabei beispielsweise im Bereich der Lackierung von industriell oder handwerklich hergestellten Gütern, wie beispielsweise Sportartikel, Gerätegehäuse und insbesondere im Bereich der Fahrzeug- und Fahrzeugteilelackierung die Erzeugung einzigartiger und eindrucksvoller Dekorationseffekte erlauben.
Es hat sich gezeigt, daß diese Aufgabe gelöst werden kann durch das einen Gegenstand der Erfindung bildende Verfahren zur dekorativen Gestaltung einer Überzugsschicht auf Substraten, die aus der Gruppe ausgewählt werden, die aus Fassadenelementen, Möbeln, Gerätegehäusen, Haushaltsgeräten, Sportartikeln, Automobilkarossen und deren Bauteilen, Fahrzeugen und Fahrzeugteilen besteht (im folgenden einfach als "Substrate" bezeichnet) das dadurch gekennzeichnet ist, daß ein aushärtbares Überzugsmittel auf die Substratoberfläche aufgebracht und ein oder mehrere Prägematrizen jeweils mit ihrer ein durch im Bereich von 100 bis 20000 nm voneinander beabstandete Amplitudenmaxima charakterisiertes Relief aufweisenden Seite an der oder den zu dekorierenden Stellen in die unausgehärtete Überzugsschicht gedrückt werden, worauf zumindest die mit der oder den Prägematrizen bedeckten Bereiche zumindest teilweise ausgehärtet werden, anschließend die Prägematrize(n) entfernt und falls noch nicht ausgehärtete Stellen in der Überzugsschicht vorliegen, diese vollständig ausgehärtet werden.
Das Verfahren kann mit durch energiereiche Strahlung, wie Licht und/oder thermisch härtbaren Überzugsmitteln durchgeführt werden, wobei die Härtung durch Bestrahlung und/oder thermisch erfolgen kann.

Dementsprechend betrifft eine erste, bevorzugte Ausführungsform der Erfindung ein Verfahren zur dekorativen Gestaltung einer Substratoberfläche, das dadurch gekennzeichnet ist, daß ein durch Bestrahlung mit energiereicher Strahlung, z.B. mit Licht, aushärtbares Überzugsmittel auf die Substratoberfläche aufgebracht und ein oder mehrere teilweise oder vollständig lichtdurchlässige Prägematrizen jeweils mit ihrer ein durch im Bereich von 100 bis 20000 nm voneinander beabstandete Amplitudenmaxima charakterisiertes Relief aufweisenden Seite an der oder den zu dekorierenden Stellen in die unausgehärtete Überzugsschicht gedrückt werden, worauf zumindest die mit der oder den Prägematrizen bedeckten Bereiche durch die Prägematrize(n) hindurch mit energiereicher Strahlung, z.B. mit Licht einer Wellenlänge von 180 bis 1000 nm, bestrahlt, anschließend die Prägematrize(n) entfernt und falls noch nicht ausgehärtete Stellen in der Überzugsschicht vorliegen, diese mittels energiereicher Strahlung, insbesondere photochemisch, ausgehärtet werden.
Eine zweite Ausführungsform der Erfindung ist ein Verfahren zur dekorativen Gestaltung einer Substratoberfläche, dadurch gekennzeichnet, daß ein auf thermischem Wege aushärtbares Überzugsmittel auf die Substratoberfläche aufgebracht und ein oder mehrere Prägematrizen jeweils mit ihrer ein durch im Bereich von 100 bis 20000 nm voneinander beabstandete Amplitudenmaxima charakterisiertes Relief aufweisenden Seite an der oder den zu dekorierenden Stellen in die unausgehärtete Überzugsschicht gedrückt werden, worauf zumindest die mit der oder den Prägematrizen bedeckten Bereiche zumindest teilweise thermisch ausgehärtet werden, anschließend die Prägematrize(n) entfernt und falls noch nicht ausgehärtete Stellen in der Überzugsschicht vorliegen, diese vollständig thermisch ausgehärtet werden.
Es versteht sich, daß die vorstehend beschriebene erste, bevorzugte und zweite Ausführungsform auch miteinander zu weiteren Ausführungsformen kombiniert werden können, indem entsprechende dafür geeignete Überzugsmittel verwendet werden und beispielsweise a) zuerst photochemisch und nach Entfernen der Prägematrizen noch nicht ausgehärtete Stellen thermisch, gegebenenfalls zusätzlich photochemisch oder b) zuerst thermisch und nach Entfernen der Prägematrizen noch nicht ausgehärtete Stellen photochemisch, gegebenenfalls zusätzlich thermisch oder c) zuerst photochemisch und thermisch und nach Entfernen der Prägematrizen gegebenenfalls vorliegende, noch nicht ausgehärtete Stellen photochemisch und/oder thermisch ausgehärtet werden. Wenn in einem Verfahrensschritt photochemische und thermische Härtung miteinander kombiniert angewendet werden, so kann dies nacheinander oder gleichzeitig geschehen.

Nachfolgend wird zwecks Vereinfachung bezüglich der Prägematrize(n) und der zu dekorierende(n) Stelle(n) jeweils der Plural verwendet. An dieser Stelle sei darauf hingewiesen, daß der Ausdruck "zu dekorierende Stelle(n)" auch den speziellen Fall einer vollflächig zu dekorierenden Substratoberfläche einschließt.

Ohne eine bindende Erklärung anzugeben, wird als theoretische Erläuterung angenommen, daß der sich für den Betrachter ergebende dekorative Effekt der nach dem eründungsgemäßen Verfahren gestalteten Oberflächen im wesentlichen durch Lichtbeugung und Interferenz an den mittels der Prägematrizen erzeugten Strukturen in der Oberfläche der aus dem aushärtbaren Überzugsmittel erzeugten Überzugsschicht entsteht. Für den Betrachter ergeben die während des zumindest teilweisen Aushärtens mit den Prägematrizen versehenen Stellen je nach Betrachtungswinkel unterschiedliche optische Effekte; er nimmt sie als dekorative Elemente wahr.

Das erfindungsgemäße Verfahren eignet sich zur dekorativen Gestaltung einer Überzugsschicht, Fassadenelementen, Möbeln, Gerätegehäusen, Haushaltsgeräten, Sportartikeln, z.B. Skiern, Surfbretten, insbesondere Automobilkarossen und deren Bauteilen sowie allgemein Fahrzeugteilen. Beispielsweise kann es sich bei der dekorativ zu gestaltenden Überzugsschicht um einen Einschichtlack oder um eine im Rahmen einer Mehrschichtlackierung aufgebrachte für den Betrachter sichtbare Überzugsschicht handeln. Die mit der Überzugsschicht versehenen Güter selbst können aus beispielsweise Holz, Glas, insbesondere aber aus Metall oder Kunststoff sein und gegebenenfalls schon mit einer oder mehreren Lackschichten vorbeschichtet sein.
Die im erfindungsgemäßen Verfahren verwendeten aushärtbaren Überzugsmittel unterliegen keiner Beschränkung, es kann sich um sämtliche üblicheÜberzugsmittel handeln, die wäßrig, mit Lösemitteln verdünnt oder frei von Lösemitteln und Wasser sein können. Sie können auch pulverförmig sein.

Bei der ersten, bevorzugten Ausrührungsform des erfindungsgemäßen Verfahrens werden durch Bestrahlung mit energiereicher Strahlung, z.B. mit Licht, vollständig aushärtbare Überzugsmittel verwendet. Sie unterliegen keiner Beschränkung, sie können wäßrig, mit Lösemitteln verdünnt oder bevorzugt frei von Lösemitteln und Wasser sein. Bei den durch Bestrahlung mit Licht vollständig aushärtbaren Überzugsmitteln handelt es sich insbesondere um die dem Fachmann bekannten kationisch und/oder radikalisch härtenden Überzugsmittel. Bevorzugt sind radikalisch härtende Überzugsmittel, Bei Einwirkung energiereicher Strahlung auf aus diesen Überzugsmitteln applizierten Überzugsschichten entstehen in den Überzugsschichten Radikale, die eine Vernetzung der Überzugsschichten durch radikalische Polymerisation olefinischer Doppelbindungen auslösen.

Die bevorzugten, radikalisch härtenden Überzugsmittel enthalten Prepolymere, wie Poly-oder Oligomere, die radikalisch polymerisierbare olefinische Doppelbindungen, insbesondere in Form von (Meth)acryloylgruppen im Molekül aufweisen. Die Prepolymeren können in Kombination mit üblichen Reaktivverdünnern, d.h. reaktiven flüssigen Monomeren, vorliegen.

Beispiele für Prepolymere oder Oligomere sind (meth)acrylfunktionelle (Meth)acrylcopolymere, Epoxidharz(meth)acrylate, Polyester(meth)acrylate, Polyether(meth)acrylate, Polyurethan(meth)acrylate, ungesättigte Polyester, ungesättigte Polyurethane oder Silikon(meth)acrylate mit zahlenmittleren Molekularmassen (Mn) bevorzugt im Bereich von 200 bis 10000, besonders bevorzugt von 500 bis 3000 und mit durchschnittlich 2 bis 20, bevorzugt 3 bis 10 radikalisch polymerisierbaren, olefinischen Doppelbindungen pro Molekül.

Werden Reaktiwerdünner verwendet, so werden sie in Mengen von 1 bis 50 Gew.-% eingesetzt, bevorzugt von 5 bis 30 Gew.-%, bezogen auf das Gesamtgewicht von Prepolymeren und Reaktiwerdünnern. Es handelt sich um niedermolekulare definierte Verbindungen, die mono-, di- oder polyungesättigt sein können. Beispiele für solche Reaktivverdünner sind: (Meth)acrylsäure und deren Ester, Maleinsäure und deren Halbester, Vinylacetat, Vinylether, substituierte Vinylharnstoffe, Ethylen- und Propylenglykoldi(meth)acrylat, 1,3- und 1,4-Butandioldi(meth)acrylat, Vinyl(meth)acrylat, Allyl(meth)acrylat, Glycerintri- , -di- und -mono(meth)acrylat, Trimethylolpropantri-, -diund -mono(meth)acrylat, Styrol, Vinyltoluol, Divinylbenzol, Pentaerythrittri- und-tetra(meth)acrylat, Di- und Tripropylenglykoldi(meth)acrylat, Hexandioldi(meth)acrylat, sowie deren Gemische.

Die bevorzugten, radikalisch härtenden Überzugsmittel können übliche Photoinitiatoren enthalten, z.B. in Mengen von 0,1 bis 5 Gew.-%, bevorzugt von 0,5 bis 3 Gew.-%, bezogen auf die Summe von radikalisch polymerisierbaren Prepolymeren, Reaktiwerdünnern und Photoinitiatoren Beispiele für Photoinitiatoren sind Benzoin und -derivate, Acetophenon und -derivate, z.B. 2,2-Diacetoxyacetophenon, Benzophenon und -derivate, Thioxanthon und -derivate, Anthrachinon, 1-Benzoylcyclohexanol, phosphororganische Verbindungen, wie z.B. Acylphospinoxide. Die Photoinitiatoren können allein oder in Kombination eingesetzt werden. Außerdem können weitere synergistische Komponenten, z.B. tertiäre Amine, eingesetzt werden.

Bei der zweiten Ausführungsform können die thermisch aushärtbaren Überzugsmittel durch Additions- und/oder Kondensationsreaktionen und/oder durch radikalische oder kationische Polymerisation aushärtbare und gegebenenfalls zusätzlich physikalisch trocknende übliche Bindemittelsysteme enthalten. Bei den Additions- und/oder Kondensationsreaktionen im vorstehend genannten Sinne handelt es sich um dem Fachmann bekannte lackchemische Vernetzungsreaktionen wie beispielsweise die ringöffnende Addition einer Epoxidgruppe an eine Carboxylgruppe unter Bildung einer Ester- und einer Hydroxylgruppe, die Addition einer Hydroxylgruppe an eine Isocyanatgruppe unter Bildung einer Urethangruppe, die Reaktion einer Hydroxylgruppe mit einer blockierten Isocyanatgruppe unter Ausbildung einer Urethangruppe und Abspaltung des Blockierungsmittels, die Reaktion einer Hydroxylgruppe mit einer N-Methylolgruppe unter Wasserabspaltung, die Reaktion einer Hydroxylgruppe mit einer N-Methylolethergruppe unter Abspaltung des Veretherungsalkohols, die Umesterungsreaktion einer Hydroxylgruppe mit einer Estergruppe unter Abspaltung des Veresterungsalkohols, die Umurethanisierungsreaktion einer Hydroxylgruppe mit einer Carbamatgruppe unter Alkoholabspaltung, die Reaktion einer Carbamatgruppe mit einer N-Methylolethergruppe unter Abspaltung des Veretherungsalkohols.

Soll eine Kombination von photochemischer und thermischer Härtung erfolgen, so können die an sich durch Bestrahlung mit Licht, nach einem radikalischen Mechanismus aushärtbaren Überzugsmittel neben den Photoinitiatoren zusätzlich übliche thermisch aktivierbare Radikalinitiatoren enthalten, die ab beispielsweise 40 bis 120°C Radikale bilden können. Beispiele für thermolabile Radikalinitiatoren sind: organische Peroxide, organische Azoverbindungen oder C-C-spaltende Initiatoren. Die bevorzugten Einsatzmengen liegen zwischen 0,1 bis 5 Gew.-%, bezogen auf die Summe aus radikalisch polymerisierbaren Prepolymeren, Reaktivverdünnern und Radikalinitiatoren.

Eine weitere Möglichkeit der Kombination von photochemischer und thermischer Härtung besteht darin, durch Bestrahlung mit Licht nur teilweise aushärtbare Überzugsmittel zu verwenden, die ein Gemisch aus beispielsweise 50 bis 99 Gew.-% eines durch Bestrahlung mit Licht aushärtbaren Bindemittelsystems und 1 bis 50 Gew.-% eines durch Additions-und/oder Kondensationsreaktionen aushärtbaren und gegebenenfalls zusätzlich physikalisch trocknenden Bindemittelsystems enthalten, wobei sich die Gew.-% jeweils auf den Festkörper beziehen und sich zu 100 Gew.-% ergänzen, und/oder an sich durch Bestrahlung mit Licht aushärtbare Bindemittelsysteme zu verwenden, die zusätzliche zur Vernetzung durch Additions- und/oder Kondensationsreaktionen fähige Gruppen aufweisen. Beispiele für Additions- und/oder Kondensationsreaktionen sind die schon vorstehend genannten.

Die im erfindungsgemäßen Verfahren verwendelen aushärtbaren Überzugsmitlel können pigmentiert oder gefärbt transparent oder farblos transparent sein. Bevorzugt handelt es sich um farblose Klarlacke oder farb- und/oder effektgebende Überzugsmittel, z. B. Basislacke.

Die Überzugsmittel können durch übliche Methoden, beispielsweise durch Spritzapplikation auf die zu dekorierenden Substrate aufgebracht werden. Die Applikation kann auf die gesamte Substratoberfläche oder auf eine oder mehrere Teilflächen davon oder nur auf die zu dekorierenden Stellen der Substratoberfläche erfolgen, beispielsweise in einer Trockenschichtdicke von 5 bis 250 µm.

Nach der Applikation und einer gegebenenfalls gewährten Ablüftphase oder Aufschmelzphase werden die Prägematrizen jeweils mit ihrer ein durch im Bereich von 100 bis 20000 nm, bevorzugt von 800 bis 20000 nm voneinander beabstandete Amplitudenmaxima charakterisiertes Relief aufweisenden Seite an den zu dekorierenden Stellen in die unausgehärtete Überzugsschicht gedrückt.

Die Prägematrizen können prinzipiell aus beliebigen, für die erfindungsgemäße Anwendung geeigneten Materialien bestehen, beispielsweise aus Metall, Glas oder Kunststoff. Es kann sich um lichtundurchlässige oder teilweise oder vollständig lichtdurchlässige Prägematrizen handeln. Die insbesondere im Fall der ersten, bevorzugten Ausführungsform verwendeten, teilweise oder vollständig lichtdurchlässigen Prägematrizen können aus Glas oder bevorzugt aus transparenten Kunststoffen, beispielsweise Polyester, Polycarbonat, Polystyrol, Poly(meth)acrylat oder Silikonkunststoff bestehen. Bevorzugt ist flexibler, gegebenenfalls elastischer Kunststoff. Bei den Prägematrizen kann es sich um als Stempel verwendbare Formteile handeln oder es handelt sich um Folien, die beispielsweise mit Hilfe eines eine unstrukturierte, glatte Oberfläche aufweisenden Stempels oder einer entsprechenden Walze an den zu dekorierenden Stellen in die unausgehärtete Überzugsschicht gedrückt werden. Die Folien können als solche strukturiert sein oder sie weisen eine strukturierte Beschichtung auf. Um das Ablösen von den zu dekorierenden Stellen nach der zumindest teilweisen Aushärtung zu erleichtern, können die Prägematrizen auf ihrer ein Relief aufweisenden Seite zweckmäßigerweise speziell ausgerüstet sein. Diese Ausrüstung kann beispielsweise darin bestehen, daß das Prägematrizenmaterial als solches beispielsweise aufgrund entsprechender Additivierung Antihafteigenschaften aufweist, oder die Prägematrizenoberfläche mit einer Antihaftbeschichtung versehen wird.

Die Prägematrizen weisen auf einer Seite ein durch im Bereich von 100 bis 20000 nm, bevorzugt von 800 bis 20000 nm voneinander beabstandete Amplitudenmaxima charakterisiertes Relief auf. Das Relief kann lichtundurchlässig oder insbesondere im Fall der ersten, bevorzugten Ausführungsform Bereiche unterschiedlicher Lichtdurchlässigkeit aufweisen, z.B. vollständig lichtdurchlässig oder teilweise lichtdurchlässig sein. Die Erzeugung des Reliefs kann beispielsweise durch mechanische Verfahren, wie Einritzen oder Prägen und/oder Standardverfahren der Mikrostrukturtechnik, beispielsweise gegebenenfalls mit Ätziechniken verbundene photolithographische Verfahren, Aufdampfen, Mikrodrucktechnik oder lasergestützte Techniken erfolgen. Die Reliefs können beispielsweise Vertiefungen, Erhöhungen und/oder Löcher aufweisen.

Bei den jeweils auf einer Seite der Prägematrizen vorhandenen durch im Bereich von 100 bis 20000 nm, bevorzugt von 800 bis 20000 nm voneinander beabstandete Amplitudenmaxima charakterisierten Reliefs handelt es sich beispielsweise um solche mit einer Amplitudenhöhe im Bereich beispielsweise zwischen 100 und 5000 nm. Die Amplitudenmaxima als solche können in Form von Punkten, Linien oder ebenen, geneigten und/oder Vertiefungen aufweisenden Plateaus vorliegen. Im Falle von als Plateaus vorliegenden Amplitudenmaxima bezieht sich die Abstandsangabe von 100 bis 20000 nm, bevorzugt von 800 bis 20000 nm zwischen den Amplitudenmaxima auf den Abstand zwischen benachbarten Plateaukanten bzw. zwischen einer Plateaukante und benachbarten, als Punkte oder Linien vorliegenden Amplitudenmaxima. Das Relief kann unregelmäßige Strukturen aufweisen oder es handelt sich um regelmäßige Strukturen, wie optische Beugungsgitter, beispielsweise Kreuzgitter oder im einfachsten Fall optische Strichgitter. Die Gitterlinien können dabei nicht äquidistant oder äquidistant angeordnet sein. Bei unterschiedlichen hohen Amplitudenmaxima bezieht sich der Abstand auf den sich aus der Aufsicht ergebenden Abstand.

Die jeweils das Relief aufweisende Seite der Prägematrizen kann beliebige Flächeninhalte annehmen, beispielsweise von einigen Quadratzentimetern bis zu einigen Quadratmetern. Dabei kann das Relief als solches die gesamte Fläche der das Relief aufweisenden Seite der Prägematrizen ausmachen, d.h. Relief und Relief aufweisende Seite sind identisch und stimmen in Kontur und Flächeninhalt überein. Das Relief als solches kann jedoch auch nur einen Teil der Fläche der das Relief aufweisenden Seite der Prägematrizen ausmachen, wobei die äußere Konturlinie des Reliefs mit der äußeren Konturlinie der das Relief aufweisenden Seite übereinstimmen kann. Der Teil der Fläche der Prägematrize, der kein Relief aufweist, kann lichtdurchlässig oder lichtundurchlässig sein. Es ergeben sich vielfältige Gestaltungsmöglichkeiten für die das Relief aufweisende Seite der Prägematrizen. Beispielsweise kann die das Relief aufweisende Seite der Prägematrizen einen Reliefrahmen und gegebenenfalls innerhalb des Reliefrahmens weitere, ebenfalls durch Konturlinien begrenzte Reliefs aufweisen. Einzelne durch Konturlinien begrenzte Reliefs können dabei in einer gemeinsamen oder in verschiedenen, höhenversetzten Ebenen parallel angeordnet sein oder einzelne Reliefs weichen beispielsweise bis zu einem Winkel von maximal 10 Grad von dieser parallelen Anordnung ab. Aufgrund der vielfachen Variationsmöglichkeiten bei der Gestaltung der das Relief aufweisenden Seite der Prägematrizen können an den zu dekorierenden Stellen unterschiedlichste Dekorationselemente erzeugt werden, beispielsweise Bilder, Ornamente, Muster, Logos, Symbole, Initialen, Typbezeichnungen, etc..

Die Prägematrizen werden erfindungsgemäß, wie vorstehend bereits beschrieben, an den zu dekorierenden Stellen in die unausgehärtete Überzugsschicht gedrückt. Anschließend wird die unausgehärtete Überzugsschicht zumindest teilweise ausgehärtet. Dabei wird im Fall der ersten, bevorzugten Ausführungsform durch die in den Lack gedrückten Prägematrizen hindurch mit energiereicher Strahlung, beispielsweise mit Licht einer Wellenlänge von 180 bis 1000 nm bestrahlt oder im Fall der zweiten Ausführungsform erwärmt, beispielsweise auf Temperaturen von 20 bis 180°C, bevorzugt von 40 bis 160°C.

Als energiereiche Strahlung kann außer Licht beispielsweise auch Elektronenstrahlung eingesetzt werden. Hierfür können übliche, dem Fachmann geläufige Elektronenstrahler verwendet werden.

Bei der Bestrahlung mit Licht kann beispielsweise mono- oder polychromatisches Licht verwendet werden. Bevorzugt handelt es sich um ultraviolettes Licht. Bevorzugt sind UV-Strahlenquellen mit Emissionen im Wellenlängenbereich von 180 bis 420 nm, besonders bevorzugt von 200 bis 400 nm. Bevorzugte Beispiele für UV-Strahlenquellen sind gegebenenfalls dotierte Quecksilberhochdruck-, -mitteldruck- und -niederdruckstrahler, Gasentladungsröhren, wie z.B. Xenonniederdrucklampen, Schwarzlichtröhren, UV-Blitzlampen.

Die praktische Durchführung sowie technische Einzelheiten der Bestrahlung sind dem Fachmann bekannt und bedürfen keiner näheren Erläuterung. Beispielsweise liegt die Bestrahlungsdauer im Bereich der Dauer eines UV-Blitzes von beispielsweise 1 Millisekunde bis 5 Minuten, je nach verwendetem Bestrahlungsverfahren und Art der UV-Strahlungsquellen. Bevorzugt ist eine Bestrahlungsdauer, d.h. eine eigentliche Einwirkungszeit der UV-Strahlung von unter 5 Minuten.

Nach der zumindest teilweisen Aushärtung der zu dekorierenden Stellen werden die Prägematrizen von den zu dekorierenden Stellen entfernt.

Liegen in der Überzugsschicht noch nicht ausgehärtete Stellen vor, so werden diese nach der Entfernung der Prägematrizen im Falle der ersten, bevorzugten Ausführungsform durch Bestrahlung, insbesondere photochemisch und im Falle der zweiten Ausführungsform thermisch ausgehärtet. "Noch nicht ausgehärtete Stellen in der Überzugsschicht" können beispielsweise vorliegen, wenn ein ausschließlich photochemisch härtbares Überzugsmittel verwendet worden ist und eine zur vollständigen Aushärtung nicht ausreichende Strahlungsdosis auf die Überzugsschicht eingewirkt hat oder wenn ein ausschließlich thermisch härtbares Überzugsmittel verwendet worden ist und eine zur Aushärtung ausreichende Wärmeeinwirkung auf die Überzugsschicht nicht erfolgt ist oder bei der vorstehend erwähnten Kombination von photochemischer und thermischer Härtung beispielsweise zuerst nur photochemisch und nach Entfernen der Prägematrizen noch nicht ausgehärtete Stellen thermisch ausgehärtet wurden oder umgekehrt.

Im Falle der ersten, bevorzugten Ausführungsform beispielsweise umfaßt der Ausdruck "noch nicht ausgehärtete Stellen in der Überzugsschicht" auch solche Stellen, die bei der Bestrahlung durch die Prägematrizen hindurch nicht von der Strahlung erreicht worden sind, beispielsweise weil nur teilweise lichtdurchlässige Prägematrizen verwendet wurden und/oder außerhalb der Prägematrizen liegende Bereiche der Überzugsschicht während der Bestrahlung abgedeckt waren.

Eine ausschließliche photochemische Aushärtung noch nicht ausgehärteter Stellen in der Überzugsschicht kommt dann in Frage, wenn gemäß der ersten Ausführungsform ein durch Bestrahlung (z.B. mit Licht) vollständig aushärtbares Überzugsmittel zur Herstellung der Überzugsschicht verwendet worden ist. Bei Verwendung eines ausschließlich thermisch aushärtbaren Überzugsmittels gemäß der zweiten Ausführungsform erfolgt eine thermische Aushärtung noch nicht ausgehärteter Stellen, beispielsweise bei Temperaturen zwischen 20 und 180°C, bevorzugt zwischen 40 und 160°C. Die Wahl der Bedingungen bei der thermischen Aushärtung richtet sich beispielsweise nach der Zusammensetzung des betreffenden Überzugsmittels oder der Art der zu dekorierenden Substrate. Gleiches gilt für die photochemische Aushärtung.

Im Anschluß an das erfindungsgemäße Verfahren kann eine Klarlackschicht aus einem beliebigen Klarlacküberzugsmittel oder eine beliebige transparente Kunststoffolie auf die dekorierten Stellen oder auf die gesamte lackierte Substratoberfläche aufgebracht werden. Insbesondere im Zusammenhang mit dem Aufbringen einer abschließenden Klarlackschicht kann das erfindungsgemäße Verfahren als separater Verfahrensschritt in einem Verfahren zur Herstellung einer Mehrschichtlackierung eingesetzt werden Beispielsweise werden die dekorative Elemente aufweisenden Lackschichten nach dem erfindungsgemäßen Verfahren auf unlackierte oder mit einer ein- oder mehrschichtigen Lackierung vorbeschichtete Substrate aufgebracht und mit einer abschließenden Klarlackschicht versehen. Dabei kann so vorgegangen werden, daß die vorstehend erwähnte Aushärtung noch nicht ausgehärteter Stellen in der der Erzielung des dekorativen Effektes dienenden Überzugsschicht gemeinsam mit der Aushärtung der abschließenden Klarlackschicht auf photochemischem oder thermischem Weg erfolgt, je nach Art des für die Erzeugung der abschließenden Klarlackschicht verwendeten Klarlacküberzugmittels.

Das erfindungsgemäße Verfahren kann bevorzugt so durchgeführt werden, daß als aushärtbares Überzugsmittel ein Klarlacküberzugsmittel auf dunkle, z.B. schwarze, oder dunkel, z.B. schwarz lackierte Substrate appliziert wird. Auf dunklen Untergründen ist der erfindungsgemäß erzielbare Effekt nämlich besonders intensiv wahrnehmbar. Es ist auch möglich als aushärtbares Überzugsmittel ein farb- und/oder effektgebendes Überzugsmittel, z.B. ein Basislacküberzugsmittel zu verwenden, welches bevorzugt dunkel, besonders bevorzugt schwarz pigmentiert ist.

Mit dem erfindungsgemäßen Verfahren können lackierte Substratoberflächen mit dekorativen Elementen versehen werden, die einen betrachtungswinkelabhängigen Effekt zeigen. Abweichend vom aus dem Bereich der Effektlackierung, beispielsweise Metallidackierung bekannten betrachtungswinkelabhängigen Hell/Dunkel- und/oder Farb-Flop können mit dem erfindungsgemäßen Verfahren dekorative Elemente erzeugt werden, die einen neuartigen betrachtungswinkelabhängigen Flopeffekt, einen sogenannten "Ein/Aus-" oder "Phantom"-Flop aufweisen. Diese Begriffsprägung soll verdeutlichen, daß es sich hier um einen Flopeffekt handelt, der charakterisiert ist durch eine betrachtungswinkelabhängige Wahmehnibarkeit oder Nichtwahrnehmbarkeit der dekorativen Elemente oder Teile davon. Aus Sicht des Betrachters kann nämlich der Wechsel zwischen Wahrnehmung und Nichtwahrnehmung der dekorativen Elemente abrupt und ohne fließende Übergänge erfolgen. Die Wahrnehmung der dekorativen Elemente ist nur über einen gewissen Betrachtungswinkelbereich gegeben. In diesem Wahrnehmungswinkelbereich erscheinen die dekorativen Elemente für das menschliche Auge z.B. in allen sichtbaren Spektralfarben.

Sind die dekorativen Elemente mittels Prägematrizen mit einem unregelmäßige Strukturen aufweisenden Relief erzeugt worden, so sind die dekorativen Elemente als in z.B. allen Spektralfarben erscheinendes holographisches Bild wahrnehmbar. Sind die dekorativen Elemente im einfachsten Fall mittels einer Prägematrize mit einem als optisches Strichgitter vorliegenden Relief erzeugt worden, so sind die dekorativen Elemente in Form eines kontinuierlichen, z.B. alle Spektralfarben aufweisenden Spektrums wahrnehmbar, d.h. für den Betrachter ergibt sich ein regenbogenartiger Effekt.

Das erfindungsgemäße Verfahren kann auch angewandt werden zur teilflächigen und damit dekorativen, mehr oder minder starken Abschwächung des Reflexionsverhaltens (Entspiegelung) äußerer an sich glänzender Lacküberzugsschichten auf Substraten. Die Prägematrizen weisen dann ein Relief auf, welches geeignet ist destruktive Interferenzen in der Überzugsschicht zu erzeugen.

Mit dem erfindungsgemäßen Verfahren können lackierte Substratoberflächen eindrucksvoll dekorativ gestaltet werden. Das erfindungsgemäße Verfahren kann besonders vorteilhaft angewendet werden z.B. im Kraftfahrzeugbereich, was sowohl die Gestaltung von Kraftfahrzeugen und -teilen im handwerklichen Bereich als auch im industriellen Bereich der Erstausrüstung, insbesondere auch beispielsweise als integrierter Verfahrensschritt im Rahmen der Automobilerstlackierung, einschließt. Bei der Erstausrüstung kann es sich beispielsweise um eine dekorative Gestaltung der gesamten sichtbaren äußeren Oberfläche eines Kraftfahrzeuges, von Teilen im Innenraum eines Kraftfahrzeuges oder um eine individuelle nach Kundenwunsch erfolgende dekorative Gestaltung handeln, beispielsweise die Anbringung von Initialen des Kunden, etc., oder es handelt sich um eine serienmäßige dekorative Gestaltung, beispielsweise die Anbringung eines Firmenlogos, einer Typbezeichnung oder die dekorative Betonung von Kanten oder Übergängen zwischen verschiedenen Bereichen einer Karosserie, beispielsweise auch zwischen aneinandergrenzenden Fahrzeugteilen, etc. Im handwerklichen Bereich kann es sich ebenfalls beispielsweise um eine dekorative Gestaltung der gesamten sichtbaren äußeren Oberfläche eines Kraftfahrzeuges, von Teilen im Innenraum eines Kraftfahrzeuges oder eine individuelle nach Kundenwunsch erfolgende dekorative Gestaltung eines Kraftfahrzeug(teil)s oder um eine Reparatur bereits in entsprechender Weise dekorativ gestalteter Kraftfahrzeug(teil)e handeln. Das erfindungsgemäße Verfahren kann im handwerklichen Bereich, beispielsweise in einer Lackierwerkstatt als separater Verfahrensschritt oder als integrierter Verfahrensschritt im Rahmen einer Ganz- oder Teillackierung ausgeführt werden.

Die Erfindung wird im folgenden Beispiel näher erläutert.

### Beispiel

Ein mit einem handelsüblichen schwarzen Basislack beschichtetes Probeblech (5 cm mal 10 cm) wird mit einem lösemittelfreien 100% Festkörpergehalt aufweisenden UV-härtbaren Klarlack in 100 µm Naßschichtdicke beschichtet. Eine 3 mm dicke Glasplatte, die auf einer Seite ein durch Chrombedampfung erzeugtes, eine Maskenfläche von 2 cm mal 2 cm ausmachendes Strichgitter aufweist (Breite der als Plateau ausgebildeten Gitterlinien: 8 µm, Amplitudenhöhe der Gitterlinien: 120 nm, äquidistanter Abstand der äußeren Plateaukanten: 8 µm), wird mit ihrer das Strichgitter aufweisenden Seite in die unausgehärtete Klarlackschicht gedrückt. Anschließend wird die gesamte, teilweise durch die Glasplatte bedeckte Klarlackschicht mit einer UV-Blitzlampe (3500 Wattsekunden) mit 5 UV-Blitzen im Abstand von 4 Sekunden bestrahlt. Danach wird die Glasplatte entfernt und die zum Teil noch unausgehärtete Klarlackschicht analog mit 5 UV-Blitzen bestrahlt. Bei Aufsichtbetrachtung im Weißlicht nimmt man in der Klarlackoberfläche einen 2 cm mal 2 cm großen Bereich als Regenbogenfarben aufweisendes Spektrum wahr. Beim Abkippen des Probeblechs nimmt man den regenbogenfarbigen Bereich ab einem bestimmten Betrachtungswinkel plötzlich nicht mehr wahr.

## Patentansprüche

1. Verfahren zur dekorativen Gestaltung einer Überzugsschicht auf Substraten, die aus der Gruppe ausgewählt werden, die aus Fassadenelementen, Möbeln, Gerätegehäusen, Haushaltsgeräten, Sportartikeln, Automobilkarossen und deren Bauteilen, Fahrzeugen und Fahrzeugteilen besteht, **dadurch gekennzeichnet, daß** ein aushärtbares Überzugsmittel auf die zu dekorierende Substratoberfläche aufgebracht und ein oder mehrere Prägematrizen jeweils mit ihrer ein durch im Bereich von 100 bis 20000 nm voneinander beabstandete Amplitudenmaxima charakterisiertes Relief aufweisenden Seite an der oder den zu dekorierenden Stellen in die unausgehärtete Überzugsschicht gedrückt werden, worauf zumindest die mit der oder den Prägematrizen bedeckten Bereiche zumindest teilweise ausgehärtet werden, anschließend die Prägematrize(n) entfernt und falls noch nicht ausgehärtete Stellen in der Überzugsschicht vorliegen, diese vollständig ausgehärtet werden.

2. Verfahren nach Anspruch 1, **dadurch gekennzeichnet, daß** ein durch Bestrahlung mit energiereicher Strahlung aushärtbares Überzugsmittel und ein oder mehrere teilweise oder vollständig für die energiereiche Strahlung durchlässige Prägematrizen verwendet werden, worauf zumindest die mit der oder den Prägematrizen bedeckten Bereiche durch die Prägematrize(n) hindurch mit energiereicher Strahlung bestrahlt werden und anschließend die Prägematrize(n) entfernt und falls noch nicht ausgehärtete Stellen in der Überzugsschicht vorliegen, diese durch energiereiche Strahlung ausgehärtet werden.

3. Verfahren nach Anspruch 2, **dadurch gekennzeichnet, daß** ein durch Bestrahlung mit Licht aushärtbares Überzugsmittel verwendet wird und die Aushärtung durch Bestrahlung mit Licht erfolgt.

4. Verfahren nach Anspruch 3, **dadurch gekennzeichnet, daß** mit Licht einer Wellenlänge von 180 bis 1000 nm bestrahlt wird.

5. Verfahren nach Anspruch 1, **dadurch gekennzeichnet, daß** ein auf thermischem Wege aushärtbares Überzugsmittel verwendet wird, zumindest die mit der oder den Prägematrizen bedeckten Bereiche zumindest teilweise thermisch ausgehärtet werden, und anschließend die Prägematrize(n) entfernt und falls noch nicht ausgehärtete Stellen in der Überzugsschicht vorliegen, diese vollständig thermisch ausgehärtet werden.

6. Verfahren nach Anspruch 1, **dadurch gekennzeichnet, dass** es sich bei dem aushärtbaren Überzugsmittel um farblose Klarlacke oder farb- und/oder effektgebende Überzugsmittel handelt.

7. Verfahren nach einem der vorhergehenden Ansprüche 1 bis 5, **dadurch gekennzeichnet, daß** vor oder nach dem vollständigen Aushärten eine transparente Überzugsschicht aufgebracht wird.

8. Verfahren nach einem der vorhergehenden Ansprüche 1 bis 5 oder 7, **dadurch gekennzeichnet, daß** nach dem vollständigen Aushärten eine transparente Folie appliziert wird.

9. Verfahren nach einem der vorhergehenden Ansprüche 1 bis 5, 7 oder 8, **dadurch gekennzeichnet, daß** es zur Dekoration oder Beschriftung von Kraftfahrzeugen oder deren Teilen durchgeführt wird.

10. Fassadenelemente, Möbel, Gerätegehäuse, Haushaltsgeräte, Sportartikel, Automobilkarossen und deren Bauteile, Fahrzeuge und Fahrzeugteile mit dekorativer Oberfläche oder Teiloberfläche, erhalten nach dem Verfahren eines der Ansprüche 1 bis 5, 7, 8 oder 9.

## Claims

1. Process for producing a decoration on a coating layer on substrates selected from the group consisting of facade elements, furniture, appliance casings, domestic appliances, sports articles, motor vehicle bodies and components thereof, motor vehicles and motor vehicle parts, **characterised in that** a curable coating composition is applied to the substrate surface to be decorated, and one or more embossing matrices are pressed, in each case with the side having a relief **characterised by** amplitude maxima that are at a distance from one another in the range from 100 to 20,000 nm, into the uncured coating layer at the area(s) to be decorated, whereupon at least the regions covered by the embossing matrix/matrices are cured at least partly, the embossing matrix/matrices is/are subsequently removed and, if there are any uncured areas in the coating layer, those areas are cured fully.

2. Process according to claim 1, **characterised in that** there are used a coating composition that is curable by irradiation with high-energy radiation, and one or more embossing matrices that are partly or wholly permeable to high-energy radiation, whereupon at least the regions covered by the embossing matrix/matrices are irradiated with high-energy radiation through the embossing matrix/matrices, and the embossing matrix/matrices is/are subsequently removed and, if there are any uncured areas in the coating layer, those areas are cured by means of high-energy radiation.

3. Process according to claim 2, **characterised in that** a coating composition that is curable by irradiation with light is used, and curing is effected by irradiation with light.

4. Process according to claim 3, **characterised in that** irradiation is carried out with light of a wavelength of from 180 to 1000 nm.

5. Process according to claim 1, **characterised in that** a coating composition that is curable by thermal means is used, at least the regions covered by the embossing matrix/matrices are at least partly cured thermally, and the embossing matrix/matrices is/are subsequently removed and, if there are any uncured areas in the coating layer, those areas are fully cured thermally.

6. Process according to claim 1, **characterised in that** the curable coating composition is a colourless clear lacquer or a colour- and/or effect-giving coating composition.

7. Process according to any one of the preceding claims 1 to 5, **characterised in that** a transparent coating layer is applied before or after the full curing.

8. Process according to any one of the preceding claims 1 to 5 or 7, **characterised in that** a transparent film is applied after the full curing.

9. Process according to any one of the preceding claims 1 to 5, 7 or 8, **characterised in that** it is carried out for the decoration or inscription of motor vehicles or parts thereof.

10. Facade elements, furniture, appliance casings, domestic appliances, sports articles, motor vehicle bodies and components thereof, motor vehicles and motor vehicle parts having a decorative surface or part surface, obtained by the process of any one of claims 1 to 5, 7, 8 or 9.

## Revendications

1. Procédé de réalisation d'un effet décoratif d'une couche de revêtement sur des substrats, qui sont choisis parmi le groupe des éléments de façades, des meubles, des boîtiers d'appareillage, des appareils ménagers, des articles de sport, des carrosseries d'automobiles et de leurs éléments, des véhicules et pièces de véhicules, **caractérisé en ce que** l'on applique un agent de revêtement durcissable sur la surface du substrat à décorer, et l'on presse une ou plusieurs matrices d'estampage chaque fois par leur face présentant un relief **caractérisé par** des maxima d'amplitude distants l'un de l'autre dans l'intervalle allant de 100 à 20 000 nm, sur le ou les endroits à décorer dans la couche de revêtement non durcie, ce par quoi au moins les zones recouvertes de la ou des matrices d'estampage sont au moins partiellement durcies, ensuite la ou les matrices d'estampage sont enlevées et si des endroits encore non durcis sont présents dans la couche de revêtement, on durcit complètement ceux-ci.

2. Procédé selon la revendication 1, **caractérisé en ce que** l'on utilise un agent de revêtement durcissable par irradiation avec un rayonnement énergétique et une ou plusieurs matrices d'estampage transparentes partiellement ou complètement, au rayon énergétique, ce par quoi au moins les zones couvertes par la ou les matrices d'estampage sont irradiées à travers la ou les matrices d'estampage par un rayonnement énergétique et ensuite, on enlève la ou les matrices d'estampage et si des endroits non encore durcis sont présents dans la couche de revêtement, on durcit ceux-ci par le rayonnement énergétique.

3. Procédé selon la revendication 2, **caractérisé en ce que** l'on utilise un agent de revêtement durcissable par irradiation avec de la lumière et le durcissement est réalisé par irradiation avec de la lumière.

4. Procédé selon la revendication 3, **caractérisé en ce que** l'on irradie avec une lumière ayant une longueur d'onde allant de 180 à 1000 nm.

5. Procédé selon la revendication 1, **caractérisé en ce que** l'on utilise un agent de revêtement durcissable par une voie thermique, au moins les zones recouvertes par la ou les matrices d'estampage sont au moins partiellement thermiquement durcis et ensuite, la ou les matrices d'estampage sont enlevées et si des endroits non encore durcis de la couche de revêtement sont présents, on durcit ceux-ci complètement thermiquement.

6. Procédé selon la revendication 1, **caractérisé en ce que** l'agent de revêtement durcissable consiste en un vernis incolore ou un agent de revêtement donnant de la couleur et/ou un effet.

7. Procédé selon l'une des revendications précédentes 1 à 5, **caractérisé en ce qu'**avant ou après le durcissement complet, on applique un agent de revêtement transparent.

8. Procédé selon l'une des revendications précédentes 1 à 5, 7, **caractérisé en ce que** l'on applique après le durcissement complet, une feuille transparente.

9. Procédé selon l'une des revendications précédentes 1 à 5, 7 ou 8, **caractérisé en ce qu'**il est réalisé pour la décoration ou l'inscription de véhicules lourds ou de leurs pièces.

10. Eléments de façade, meubles, boîtiers d'appareillage, appareils ménagers, articles de sports, carrosseries d'automobile et leurs éléments, véhicules et pièces- de véhicules avec surface ou partie de surface décorative, obtenue selon le procédé de l'une des revendications 1 à 5, 7, 8 ou 9.
